# EUROPÄISCHE PATENTANMELDUNG

(11) **EP 2 323 191 A2**
(43) Veröffentlichungstag der Anmeldung: **18.05.2011**
(21) Anmeldenummer: 10191333.3
(22) Anmeldetag: 16.11.2010
(51) Int. Cl.: H01L 51/52, H01L 51/44

(54) **Organisches photoelektrisches Bauelement**

(30) Priorität: 17.11.2009 DE 102009046755
(71) Anmelder: Fraunhofer-Gesellschaft zur Förderung der Angewandten Forschung e.V., 80686 München (DE)
(72) Erfinder: Hesse, Jan, 01178, Dresden (DE); Amelung, Jörg, 01099, Dresden (DE); Kirchhof, Christian, 01099, Dresden (DE)
(74) Vertreter: Schenk, Markus

(57) **Zusammenfassung**

Ein organisches photoelektrisches Bauelement weist ein Substrat, eine Grundelektrode, einen Elektrodenanschluss, eine Deckelelektrode, eine organische Funktionsschicht und ein selbsttragendes Deckbauglied auf. Die Grundelektrode ist oberhalb einer ersten Oberfläche des Substrates ausgebildet und der Elektrodenanschluss ist von oberhalb der ersten Oberfläche des Substrates zugänglich. Das selbsttragende Deckbauglied dient dem Verkapseln der organischen Funktionsschicht, welche zwischen dem Substrat und dem selbsttragenden Deckbauglied angeordnet ist, wobei das selbsttragende Deckbauglied aus leitfähigem Material gebildet ist oder mit einem leitfähigen Material an einer dem Substrat zugewandten Seite beschichtet ist. Das leitfähige Material ist lokal an lateral verteilten Orten mit der Grundelektrode oder der Deckelelektrode elektrisch leitfähig gekoppelt und weiterhin mit dem Elektrodenanschluss elektrisch leitfähig gekoppelt.

## Beschreibung

Die vorliegende Erfindung bezieht sich auf ein organisches photoelektrisches Bauelement, wie z.B. eine organische Leuchtdiode oder eine organische Photozelle.

Auf der Basis organischer Leuchtdioden (Organic light emitting diodes, OLED) können neuartige Flächenlichtelemente verwirklicht werden. Als flächiger Leuchtkörper mit gegenüber der LED moderater Leuchtdichte ist die OLED ideal geeignet für die Herstellung flächiger diffuser Lichtquellen. Diesen Lichtquellen wird eine ähnlich stürmische Entwicklung vorhergesagt, wie der der OLED basierenden Displays. Hierbei kann in ferner Zukunft die OLED durch ihre Dünnschichttechnologie auch die Realisierung von flexiblen Leuchtkörpern ermöglicht werden, die ganz neue Anwendungen in der Beleuchtung von Räumen gestatten.

Da die OLED ein stromgetriebenes Bauelement ist, ist ein wichtiger Punkt bei der Herstellung großflächiger Leuchtelemente die homogene Stromdichteverteilung auf großen Flächen. Diese Homogenität ist limitiert durch die Notwendigkeit mindestens eines transparenten Kontaktes, welches normalerweise durch transparent leitfähige Oxide (TCO) oder durchsichtige Metallschichten realisiert wird. Aufgrund der geringen Leitfähigkeit dieser TCO limitieren diese Schichten die maximale Leuchtflächengröße.

Solarzellen auf Basis organischer Materialien (OPVZ) sind im Aufbau vergleichbar mit OLED, aufgrund der verwendeten organischen Materialien ermöglichen diese Strukturen aber eine Umwandlung optischer Strahlung in elektrischen Strom. Dieser Strom muss über die Kontakte abgeleitet werden. Auch hier vermindert der transparente elektrische Kontakt die maximal nutzbare Bauelementgröße.

Ein bereits bekannter Aufbau einer OLED- bzw. OPVZ beinhaltet neben einem Substrat mit transparenter Grundelektrodenschicht aus beispielsweise ITO, ZnO, eine Substratmetallisierung, Isolationsschichten, den Stapel der organischen Funktionsschichten (HTL, Isolation, Emitter, ETL) sowie eine metallische Deckelelektrode. Ein Deckglas auf der Innenseite mit Kavitäten versehen, wird mittels Verkapselungsklebstoff auf das Substrat geklebt und schließt die Funktionsschichten nach außen hin ab.

Sowohl bei organischen Leuchtdiodenflächen (OLED) als auch bei organischen Solarzellen (OPVZ) ist ein hoher Füllgrad (Verhältnis zwischen aktiver Fläche und Gesamtfläche) ein sehr wichtiges Kriterium für die Einsatzfähigkeit. Bei OLED bzw. OPVZ limitieren zwei Faktoren diesen Füllgrad.

Der erste Faktor ist die Verkapselung. Die Verkapselung erfolgt üblicherweise mindestes durch eine Dünnschichtverkapselung, die den Schichtaufbau vor Luft und Luftfeuchtigkeit schützt. Am weitesten verbreitet und für die Verwendung als Lichtquelle in marktfähigen Produkten notwendig ist ein mechanischer Schutz der organischen Schichten, der nur über eine Verkapselung mittels eines Deckglases realisierbar ist. Dieses Deckglas wird im nicht aktiven Randbereich der OLED bzw. OPVZ in der Regel mittels eines unter UV-Licht aushärtenden Klebstoffs auf das Substrat geklebt. Dieser Klebebereich, der zur Gewährleistung einer Barrierewirkung gegenüber Luft sowie zur Gewährleistung der mechanischen Stabilität nicht beliebig minimiert werden kann, steht für die aktive Leuchtfläche nicht zur Verfügung.

Der zweite Faktor ist die notwendige elektrische Kontaktierung der OLED bzw. OPVZ, die ebenfalls im Randbereich, jedoch außerhalb des Deckglases erfolgt. In diesem Bereich sind üblicherweise Kontaktflächen aufgebracht, von denen Metallleitbahnen unter dem Deckglas hindurch zu den Elektroden führen.

Diese beiden Faktoren, Klebefläche und Kontaktflächen, führen zu einer Reduzierung der aktiven Fläche der OLED bzw. OPVZ sowie zu einem signifikanten nichtleuchtenden Rand bei der OLED und einem nicht Licht-absorbierenden Rand bei der OPVZ.

Dies hat neben einem vergleichsweise geringen Füllgrad zur Folge, dass bei Aneinanderreihen mehrerer OLED-Elemente zur Erzielung einer großen Leuchtfläche immer ein deutlich sichtbares nichtleuchtendes Gitter vorhanden ist.

Ein Standardaufbau einer OLED und einer Solarzelle bzw. OPZV beinhaltet eine transparente ITO-Schicht (Indium-Zinn-Oxid) als Topelektrode auf Glas mit ca. 100 nm Dicke, eine organische Schicht (mit teilweise bis zu 7 Sublagen) mit ca. 100-200 nm Dicke und eine metallische Kathode (meistens aus Aluminium) mit ca. 100-500 nm Dicke. Wobei die jeweiligen Schichtdicken begrenzt sind und sich nicht beliebig erhöhen lassen um beispielsweise einen geringeren Schichtwiderstand der Elektrodenschichten zu erreichen. Eine Variante dieses Aufbaus ist bei der Nutzung nichttransparenter Substrate die Nutzung einer transparenten Topelektrode (dünnes Metall oder ITO) um eine Auskopplung bzw. Einkopplung des Lichtes über die Topelektrode zu erreichen.

Bei großflächigen Bauelementen führt der hochohmige Widerstand der transparenten Schicht (ca. 10-100 Ohm/square), also der ITO-Schicht bzw. Topelektrode zu einer Inhomogenität der Stromeinspeisung, da die Kontakte der Schicht nur am Rand des Leuchtelementes möglich sind. Dies limitiert die maximale Größe auf ca. 50x50 mm².

Zur Erreichung größerer Leuchtflächen werden insbesondere Metallverstärkungen in Form von Netzen in die transparente Schicht eingebracht. Diese Metallnetze (auch "busbars" oder "grids" genannt) erniedrigen den effektiven Schichtwiderstand entsprechend deren Belegungsdichte und ermöglichen somit die Realisierung größerer Leuchtflächen.

Aufgrund der Nichttransparenz dieser Grids bzw. Netze erniedrigen sie die effektive Bauelementfläche. Aus diesem Grunde sind Metallgrids bzw. Metallnetze bis ca. 25 % der ITO Fläche überhaupt sinnvoll. Eine sinnvolle Verbesserung wäre die Erhöhung der Gridmetalldicke bzw. der Dicke der Leitungen des Metallnetzes, was aber aufgrund der Strukturierungsmöglichkeiten und der Schichtdicken der organischen Schichten nicht sinnvoll ist.

Die Außenkontakte der OLED/OPVZ Elemente werden über Federkontakte oder ähnliche elektrische Kontakten mit einer Verteilerplatte verbunden. Da über diese Kontakte der Gesamtstrom für Anode und Kathode zugeführt bzw. abgeleitet wird, muss der Kontakt zumindest zweigeteilt sein. Um bei dieser Konfiguration eine homogene Lichtverteilung zu erreichen ist eine seitliche breite Kontaktierungsleitung notwendig, was die aktive Leuchtfläche bzw. die optisch aktive Fläche vermindert.

Eine Alternative zur Randkontaktierung stellt die Rückseitenkontaktierung dar, bei der im Falle einer durch das Substrat emittierenden OLED über die Deckelektrode eine Isolationsschicht und darauf eine weitere Metallschicht aufgebracht wird, welche über eine Durchkontaktierung mit der unter den organischen Schichten liegenden transparenten Elektrode verbunden ist.

Aufgrund des trotzdem erforderlichen Deckglases ist jedoch auch hier ein inaktiver Bereich für die Verklebung des Deckglases auf das Substrat notwendig. Weiterhin ist zumindest an einer Seite der OLED auch eine Kontaktierungsfläche notwendig, was an dieser Seite den nichtleuchtenden Randbereich vergrößert.

Ein weiteres Problem stellen die Deckgläser zur Verkapselung der OLED-/OPVZ-Elemente dar, die zur Aufnahme der Funktionsschichten und Absorptionsmaterialien Kavitäten aufweisen müssen. Diese Kavitäten sind nur über ressourcenaufwendige Herstellungsverfahren (im Allgemeinen durch Ätzen) produzierbar, was sich insbesondere bei großflächigen OLED/OPVZ-Elementen in einem hohen Stückpreis widerspiegelt. Zudem weist das Herstellungsverfahren aufgrund der zum Einsatz kommenden Ätz-Chemikalien ein hohes Schädigungspotential für die Umwelt auf.

Ausgehend von diesem Stand der Technik liegt der vorliegenden Aufgabe zugrunde, ein Konzept zu schaffen, welches ein besseres Flächennutzungsverhältnis bei einem organischen photoelektrischen Bauelement ermöglicht, das heißt ein besseres Verhältnis zwischen optisch aktiver und optisch inaktiver Fläche und/oder eine einfachere Herstellung und/oder eine lateral gleichmäßigere Abstrahlung oder Empfindlichkeit ermöglicht.

Diese Aufgabe wird durch ein organisches photoelektrisches Bauelement nach Anspruch 1 gelöst.

Der Kerngedanke der vorliegenden Erfindung besteht darin, dass bei einem organischen photoelektrischen Bauelement, das ein Substrat, eine Grundelektrode, eine Deckelelektrode, eine organische Funktionsschicht und ein selbsttragendes Deckbauglied aufweist, ein besseres Flächennutzungsverhältnis erzielt werden kann, wenn das selbstragende Deckbauglied aus einem leitfähigen Material gebildet ist oder mit einem leitfähigen Material beschichtet ist. Das leitfähige Material des selbsttragenden Deckbaugliedes kann beispielsweise lokal an lateral verschiedenen Orten mit der Grundelektrode oder der Deckelelektrode leitfähig gekoppelt sein und ist mit dem Elektrodenanschluss leitfähig gekoppelt. Eine Beschichtung des selbsttragenden Deckbauglieds mit leitfähigem Material, kann beispielsweise an einer dem Substrat zugewandten Seite des selbsttragenden Deckbauglieds ausgeführt sein. Da das Deckbauglied ausreichend stabil ausgebildet werden kann, sind den lateralen Leiteigenschaften des leitfähigen Materials und damit der lateralen Verteilung der Strominjektion in die Deckelelektrode oder die Grundelektrode kaum Grenzen gesetzt. Vorzugsweise ist das organische photoelektrische Bauelement als Substratemitter bzw. Substratabsorber ausgeführt bzw. ist das Substrat für Nutzwellenlängen des organischen photoelektrischen Bauelements transparent ebenso wie die Grundelektrode. Das selbsttragende Deckbauglied kann weiterhin beispielsweise zur Verkapselung der organischen Funktionsschicht dienen.

Ein Vorteil der vorliegenden Erfindung ist damit, dass durch die Nutzung eines elektrisch leitfähigen Deckbauglieds bzw. eines Deckbauglieds mit einer elektrisch leitfähigen Beschichtung eine Verringerung der inaktiven Randbereiche eines organischen photoelektrischen Bauelements ermöglicht wird und damit zu einer größeren optisch aktiven Fläche des organischen photoelektrischen Bauelements führt.

Insbesonders kann aufgrund der Nutzung eines elektrisch leitfähigen Deckbauglieds bzw. eines Deckbauglieds mit einer elektrisch leitfähigen Beschichtung in Ausführungsbeispielen der Erfindung auf die im Stand der Technik beschriebenen Metallnetze zur Erniedrigung des Schichtwiderstandes verzichtet werden, wodurch sich die optisch aktive Fläche des organischen photoelektrischen Bauelements noch weiter erhöht und/oder der Herstellungsaufwand verringert und/oder sich das Leuchtvermögen erhöht.

Weiterhin ermöglicht die einfach herzustellende leitfähige Beschichtung des selbstragenden Deckbauglieds bzw. das einfach herzustellende leitfähige selbstragende Deckbauglied eine Einspeisung des Strom in die elektrisch leitfähige Beschichtung oder in das elektrisch leitfähige Deckbauglied an nur einem Anschluss von außen an einem Gehäuse des organischen photoelektrischen Bauelements, was zu einer weiteren Verbesserung des Flächennutzungsverhältnis führt.

Ausführungsbeispiele von organischen photoelektrischen Bauelemente können beispielsweise als eine OLED (organische lichtemittierende Diode), eine OLED-Struktur oder auch als OPVZ (organische Photovoltaikzelle-organische Solarzelle) ausgebildet sein.

Eine organische Leuchtdiode wird im Folgenden auch kurz als OLED bezeichnet. Eine organische Photovoltaikzelle wird im Folgenden auch als organische Solarzelle oder kurz als OPVZ bezeichnet. Ein organisches photoelektrisches Bauelement wird im Folgenden auch kurz als OLED/OPVZ bezeichnet.

Ein selbsttragendes Deckbauglied wird im Folgenden auch manchmal als Verkapselungselement bezeichnet.

Ausführungsbeispiele der vorliegenden Erfindung ermöglichen damit die Herstellung großformatiger OLED-Leuchtelemente und organischen Solarzellen (OPVZ), einen besseren Eindruck bei einer Aneinanderreihung mehrerer OLED-Elemente durch geringere und damit weniger sichtbare inaktive Bereiche zwischen den einzelnen Elementen und eine größere optisch aktive Fläche bei der Aneinanderreihung mehrerer OPVZ-Elemente.

Bevorzugte Ausführungsbeispiele der vorliegenden Erfindung werden nachfolgend Bezug nehmend auf die beiliegenden Zeichnungen näher erläutert. Es zeigen:
- Fig. 1: eine Schnittansicht durch ein organisches photoelektrisches Bauelement gemäß einem ersten Ausführungsbeispiel der vorliegenden Erfindung.
- Fig. 2: eine Schnittansicht durch ein photoelektrisches Bauelement gemäß einem zweiten Ausführungsbeispiel der vorliegenden Erfindung.
- Fig. 3: eine Schnittansicht durch ein photoelektrisches Bauelement gemäß einem dritten Ausführungsbeispiel der vorliegenden Erfindung.
- Fig. 4: eine Schnittansicht durch ein photoelektrisches Bauelement gemäß einem vierten Ausführungsbeispiel der vorliegenden Erfindung.
- Fig. 5: eine Schnittansicht durch ein photoelektrisches Bauelement gemäß einem fünften Ausführungsbeispiel der vorliegenden Erfindung.
- Fig. 6: eine Schnittansicht durch ein organisches photoelektrisches Bauelement gemäß einem sechsten Ausführungsbeispiel der vorliegenden Erfindung.
- Fig. 7: eine Schnittansicht durch ein organisches photoelektrisches Bauelement gemäß einem siebten Ausführungsbeispiel der vorliegenden Erfindung.
- Fig. 8: eine Schnittansicht durch ein organisches photoelektrisches Bauelement gemäß einem achten Ausführungsbeispiel der vorliegenden Erfindung.
- Fig. 9: eine Schnittansicht durch ein organisches photoelektrisches Bauelement gemäß einem neunten Ausführungsbeispiel der vorliegenden Erfindung.
- Fig. 10: eine Schnittansicht durch ein organisches photoelektrisches Bauelement gemäß einem zehnten Ausführungsbeispiel der vorliegenden Erfindung.
- Fig. 11: eine Schnittansicht durch ein organisches photoelektrisches Bauelement gemäß einem elften Ausführungsbeispiel der vorliegenden Erfindung.
- Fig. 12: eine Rückseitenansicht eines organischen photoelektrischen Bauelements gemäß einem zwölften Ausführungsbeispiel der vorliegenden Erfindung.

Bevor im Folgenden die vorliegende Erfindung anhand der Zeichnungen näher erläutert wird, wird darauf hingewiesen, dass gleiche Elemente in den Figuren mit den gleichen oder ähnlichen Bezugszeichen versehen sind und dass eine wiederholte Beschreibung dieser Elemente weggelassen wird.

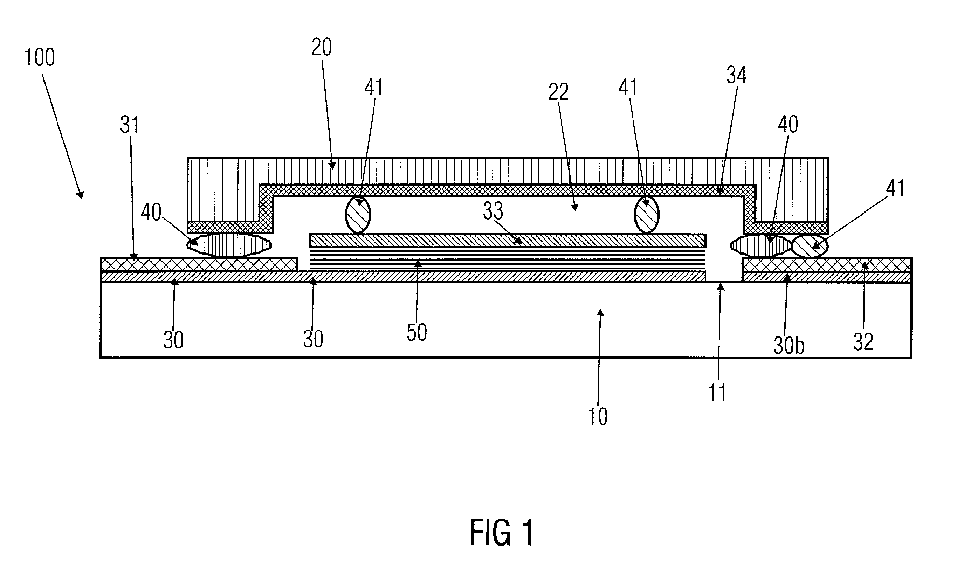

Fig. 1 zeigt eine Schnittansicht durch ein organisches photoelektrisches Bauelement gemäß einem ersten Ausführungsbeispiel der vorliegenden Erfindung. Das organische photoelektrische Bauelement 100 weist ein Substrat 10, das eine Oberfläche 11 umfasst, auf. Auf der Oberfläche 11 ist eine Grundelektrode 30a, sowie eine elektrisch isolierte Teilgrundelektrode 30b ausgebildet. Daran anschließend ist eine Deckelelektrode 33 ausgebildet, so dass eine organische Funktionsschicht 50 zwischen der Deckelelektrode 33 und der Grundelektrode 30 angeordnet ist. Die laterale Ausdehnung der organischen Funktionsschicht 50 ist beispielsweise gleich der lateralen Ausdehnung der Deckelelektrode oder weicht von dieser nur geringfügig ab. Die Grundelektrode 30a weist an einem ihrer Ränder auf einer der Oberfläche 11 abgewandten Oberfläche eine Substratmetallisierung 31 auf. Die Teilgrundelektrode 30b weist auf einer der Oberfläche 11 abgewandten Oberfläche eine Substratmetallisierung 32 auf, welche in ihren lateralen Ausmaßen beispielsweise denen der Teilgrundelektrode 30b entspricht oder weicht von dieser nur geringfügig ab. Auf einer nicht der Teilgrundelektrode 30b zugewandten Oberfläche der Substratmetallisierung 32 ist ein Verkapselungsklebstoff 40 und elektrisch leitfähiger Klebstoff 41 angeordnet, an welchen eine elektrisch leitfähige Beschichtung 34 eines selbsttragenden Deckbauglieds 20 angrenzt. Auf einer nicht der Grundelektrode 30 zugewandten Oberfläche der Substratmetallisierung 31 ist weiterer Verkapselungsklebstoff 40 angeordnet, an welchen die elektrisch leitfähige Beschichtung 34 des selbsttragenden Deckbauglieds 20 angrenzt. Das selbsttragende Deckbauglied 20 umfasst eine Kavität 22, in welcher der Schichtstapel aus einem Teil der Grundelektrode 30, der organischen Funktionsschicht 50, und der Deckelelektrode 33 angeordnet ist. Die Substratmetallisierungen 31 und 32 sowie die, an die Substratmetallisierungen 31 und 32 angrenzenden Grundelektrode 30 und Teilgrundelektrode 30b überragen lateral den von dem selbstragenden Deckbauglied 20 verkapselten Bereich, um so eine Kontaktierung der Substratmetallisierung 31, welche als Anodenanschluss 31 ausgebildet sein kann und der Substratmetallisierung 32, welche als Kathodenanschluss 32 ausgebildet sein kann, zu ermöglichen. Innerhalb der Kavität 22 ist die elektrisch leitfähige Beschichtung 34 durch einen elektrisch leitfähigen Klebstoff 41 beispielsweise an mehreren Stellen elektrisch leitfähig mit der Deckelelektrode 33 verbunden.

Das selbsttragende Deckbauglied 20 kann beispielsweise als ein Deckglas 20 ausgebildet sein, wobei als Material für das Deckglas 20 nicht zwangsläufig Glas eingesetzt werden muss, sondern beispielsweise auch ein transparenter Kunststoff verwendbar wäre, um beispielsweise flexible Vorrichtungen zu realisieren. Die Kavität 22 des Deckglass 20 kann beispielsweise über ein subtraktives Verfahren in ein planes Glas geätzt, geprägt oder gefräst werden. Die elektrisch leitfähige Beschichtung 34 des Deckglases 20 kann beispielsweise als eine Deckglasmetallisierung 34 ausgeführt sein.

Ein Deckglas kann im Folgenden auch als Verkapselungsglas oder Kapselungsglas bezeichnet werden.

Die Metallisierung des Deckglases 20 oder eine Beschichtung des Deckglases 20 mit einem anderen leitfähigen Material hat den Zweck, den auf die Deckglasmetallisierung 34 bzw. die Beschichtung 34 des Deckglases 20, beispielsweise über die Substratmetallisierung 32 eingeleiteten Strom mittels eines elektrisch leitenden Klebstoffs 41 auf das Deckglas 20 zu führen bzw. mit Hilfe des Deckglases 20, als Träger der Deckglasmetallisierung 34 den Strom gleichmäßig zu verteilen. Die Deckglasmetallisierung 34 leitet den Strom zu weiteren Kontaktpunkten, die sich an anderen Stellen des Randbereiches des optischen photoelektrischen Bauelements 100 oder verteilt auf der gesamten Fläche des Deckglases 20 befinden können weiter. Die verteilten Kontaktpunkte wiederum führen mittels elektrisch leitfähigen Klebstoffs 41 den Strom auf die Deckelelektrode 33. Somit kann eine gleichmäßige Stromverteilung über die gesamte Fläche der Deckelelektrode 33 ermöglicht werden.

Mit anderen Worten gesagt, ist die Deckglasmetallisierung 34 mit einem elektrisch leitfähigen Klebstoff 41 mit dem Kathodenanschluss 32 bzw. mit der Substratmetallisierung 32 verbunden. Damit wird erreicht, dass die inaktiven Randbereiche minimiert werden, indem die Substratmetallisierung 32 nur noch die zur Verkapselung nötige Breite aufweist, und der Stromtransport bzw. die Stromverteilung hingegen durch die Deckglasmetallisierung 34 des Deckglases 20 erfolgt.

Mit anderen Worten gesagt wird durch die Kombination von Verkapselungsfläche und elektrisch leitfähiger Kontaktfläche auf der Substratmetallisierung 32 die nicht optisch aktive Randfläche des organischen photoelektrischen Bauelements 100 reduziert.

Dies ist vor allem bei großflächigen OLED/OPVZ-Substraten von Bedeutung, da mit steigender Fläche auch der Stromfluss und den für einen Verlust am Stromtransport nötige Leitungsquerschnitt ergo Leitungsbreite zunimmt.

Weiterhin wird der Strom ebenfalls mit elektrisch leitfähigem Klebstoff 41 innerhalb der Kavität 22 des Deckglases 20 auf die Deckelelektrode 33 geführt. Durch diese Lösung ist es möglich, den Strom lediglich an einer Seite bzw. Ecke des organischen photoelektrischen Bauelements einzuleiten. Die Deckglasmetallisierung 34 sorgt für eine effiziente Verteilung des Stromes auf der Fläche bzw. ermöglicht eine elektrische Verschaltung verschiedener aktiver Module auf der Substratoberfläche 11.

Die Deckglasmetallisierung 34 kann beispielsweise durch Druckverfahren aufgebracht werden. Vorzugsweise ist dafür die Kavität 22 im Deckglas 20 abgeschrägt. Andernfalls kann die Kavitätskante mit einer Paste bzw. einem Füllstoff versehen werden, um eine Metallisierung der Flanke zu ermöglichen.

Es sei erwähnt, dass die hier beschriebenen Ausführungsbeispiele ausgebildet sind, um Licht durch das Substrat hindurch zu emittieren bzw. absorbieren. Das selbsttragende Deckbauglied 20 bildet damit die Rückseite der hier beschriebenen Ausführungsbeispiele und das Substrat 10 die Vorderseite der hier beschriebenen Ausführungsbeispiele.

Weiterhin sei erwähnt, dass die laterale Ausdehnung der organischen Funktionsschicht 50 und der sie umgebenden Elektroden die optisch aktive Fläche der organischen photoelektrischen Bauelemente bestimmt.

Weiterhin sei erwähnt, dass die Grundelektrode 30 des in Fig. 1 gezeigten optischen Bauelements 100 ein Metallnetz zur Senkung des Widerstands der Grundelektrode 30 und zur besseren Stromverteilung aufweisen kann.

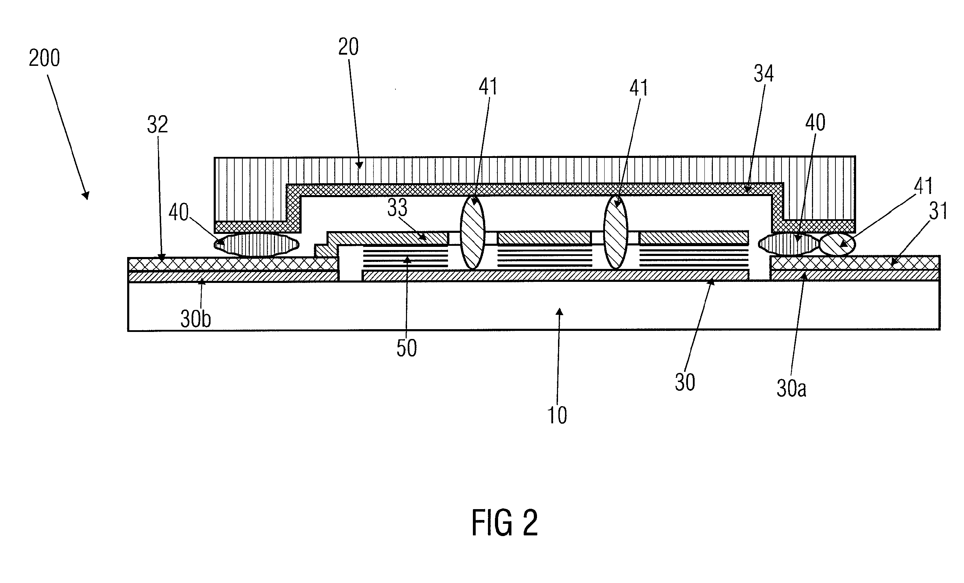

Fig. 2 zeigt eine Schnittansicht durch ein organisches photoelektrisches Bauelement 200 gemäß einem zweiten Ausführungsbeispiel der vorliegenden Erfindung. Das organische photoelektrische Bauelement 200 weist ein Substrat 10, das eine Oberfläche 11 umfasst, auf. Auf der Oberfläche 11 ist eine Grundelektrode 30, eine erste Teilgrundelektrode 30a sowie eine zweite Teilgrundelektrode 30b ausgebildet. Daran anschließend ist eine Deckelelektrode 33 ausgebildet, so dass eine organische Funktionsschicht 50 zwischen der Deckelelektrode 33 und der Grundelektrode 30 angeordnet ist. Die laterale Ausdehnung der organischen Funktionsschicht 50 ist beispielsweise gleich der lateralen Ausdehnung der Deckelelektrode oder weicht von dieser nur geringfügig ab. Die erste Teilgrundelektrode 30a weist auf einer der Oberfläche 11 abgewandten Oberfläche eine Substratmetallisierung 31 auf, welche in ihren lateralen Ausmaßen beispielsweise denen der ersten Teilgrundelektrode 30a entspricht oder nur geringfügig von dieser abweicht. Die zweite Teilgrundelektrode 30b weist auf einer der Oberfläche 11 abgewandten Oberfläche eine Substratmetallisierung 32 auf, welche in ihren lateralen Ausmaßen beispielsweise denen der zweiten Teilgrundelektrode 30b entspricht oder nur geringfügig von dieser abweicht. Auf einer nicht der ersten Teilgrundelektrode 30a zugewandten Oberfläche der Substratmetallisierung 31 ist ein Verkapselungsklebstoff 40 und elektrisch leitfähiger Klebstoff 41 angeordnet, an welchen eine elektrisch leitfähige Beschichtung 34 eines selbsttragenden Deckbauglieds 20 angrenzt. Auf einer nicht der zweiten Teilgrundelektrode 30b zugewandten Oberfläche der Substratmetallisierung 32 ist weiterer Verkapselungsklebstoff 40 angeordnet, an welchen die elektrisch leitfähige Beschichtung 34 des selbsttragenden Deckbauglieds 20 angrenzt. Das selbsttragende Deckbauglied 20 umfasst eine Kavität 22, in welcher der Schichtstapel aus der Grundelektrode 30, der organischen Funktionsschicht 50, und der Deckelelektrode 33 angeordnet ist. Die Substratmetallisierungen 31 und 32 sowie die, an die Substratmetallisierungen 31 und 32 angrenzenden Teilgrundelektroden 30a und 30b überragen lateral den von dem selbstragenden Deckbauglied 20 verkapselten Bereich, um so eine Kontaktierung der Substratmetallisierung 31, welche als Anodenanschluss 31 ausgebildet sein kann und der Substratmetallisierung 32, welche als Kathodenanschluss 32 ausgebildet sein kann, zu ermöglichen. Die Deckelelektrode 33 ist direkt mit dem Kathodenanschluss 32 bzw. der Substratmetallisierung 32 elektrisch leitfähig beispielsweise über einen leitfähigen Steg verbunden. Die Deckglasmetallisierung 34 ist elektrisch leitfähig mit der transparenten Grundelektrode 30 verbunden. Die Deckelektrode 33 sowie die organische Funktionsschicht 50 bzw. der Funktionsstapel des organischen photoelektrischen Bauelements, wie beispielsweise einer OLED weisen hierfür elektrisch isolierte Durchkontaktierungen auf. In den Durchkontaktierungen kann beispielsweise elektrisch leitender Klebstoff 41 zur elektrisch leitfähigen Verbindung der Deckglasmetallisierung 33 mit der Grundelektrode 30 angeordnet sein. Mit anderen Worten gesagt, wird der Strom vom Anodenanschluss 31 bzw. der Substratmetallisierung 31 mittels eines elektrisch leitfähigen Klebstoffs 41 auf die Deckglasmetallisierung 34 des Deckglases 20 geleitet, welche den Strom gleichmäßig verteilt oder verschiedene aktive Module miteinander elektrisch verbindet und anschließend über weiteren elektrisch leitfähigen Klebstoff 41 auf die transparente Grundelektrode 30 führt. Somit weisen die Grundelektrode 30 und die erste Teilgrundelektrode 30a ein gleiches Potential auf.

In weiteren Ausführungsbeispielen der vorliegenden Erfindung kann der elektrisch leitfähige Klebstoff 41 auch beispielsweise durch einen elektrisch leitfähigen Kontaktstift ersetzt werden. Die Durchkontaktierungen können an lokal lateral variierenden Stellen der Deckelelektrode 33 und der organischen Funktionsschicht 50 beispielsweise als Bohrungen angeordnet sein. Dabei ist zu beachten, dass die Durchkontaktierungen eine elektrische Leitfähigkeit der Deckelelektrode 33 und eine Funktion der organischen Funktionsschicht 50 nicht beeinträchtigen.

Mit anderen Worten gesagt leitet die Deckglasmetallisierung 34 den Strom zu weiteren Kontaktpunkten, die sich an anderen Stellen des Randbereiches oder verteilt auf der gesamten Fläche des Deckglases 20 befinden können, die wiederum mittels elektrisch leitfähigen Klebstoffs 41 auf die Grundelektrode 30 den Strom führen. Somit kann eine gleichmäßige Stromverteilung über die gesamte Fläche der Grundelektrode 30 ermöglicht werden.

Ein Vorteil des in Fig. 2 gezeigten optischen Bauelements 200 ist, dass aufgrund der elektrisch leitfähigen Kopplung des leitfähigen Materials 34 lokal an variierenden Orten mit der Grundelektrode 30 auf ein Metallnetz in oder auf der Grundelektrode 30 zur Senkung des Schichtwiderstand verzichtet, werden kann, wodurch sich die optische aktive Fläche erhöht und, bei Ausführung des organischen photoelektrischen Bauelements 200 als Substratemitter de optischen Eindruck und das Leuchtvermögen verbessert.

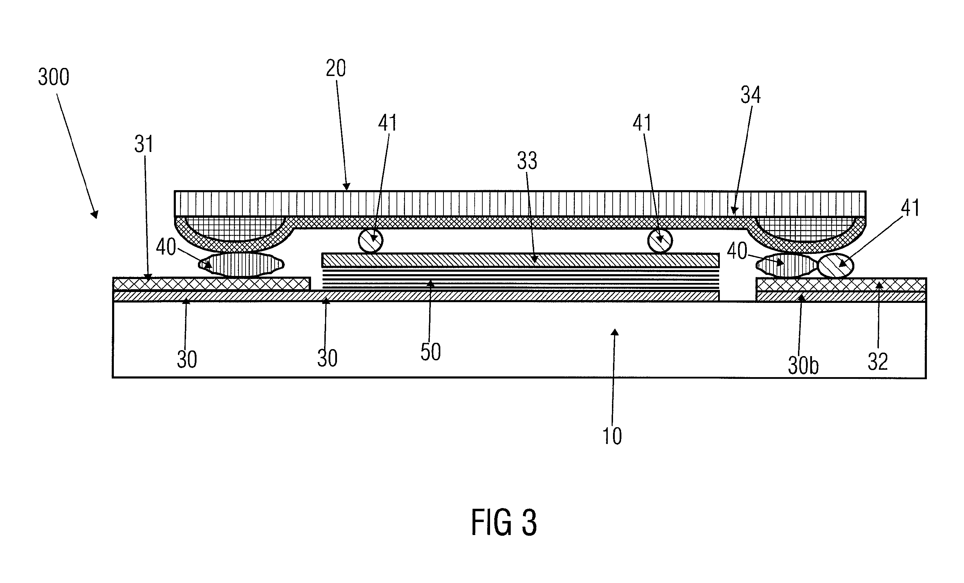

Fig. 3 zeigt eine Schnittansicht durch ein organischen photoelektrischen Bauelements 300 gemäß einem dritten Ausführungsbeispiel der vorliegenden Erfindung. Das in Fig. 3 gezeigte organische photoelektrische Bauelement 200 unterscheidet sich von dem in Fig. 1 gezeigten organischen photoelektrischen Bauelement 100 dadurch, dass statt eines mit Kavitäten 22 versehenen Glases ein planes kavitätsloses Glassubstrat als Deckglas 20 verwendet wird. Anstatt die Vertiefungen bzw. Kavitäten subtraktiv durch Ätzen zu erzeugen, wird mittels strukturiert aufgeschmolzener Glasfrittenpaste an den Rändern des Deckglases 20 ein Verkapselungsrand erzeugt, welche den für die aktiven Schichten bzw. organische Funktionsschicht 50 und die Unterbringung von Gettermaterialien erforderlichen Abstand zwischen dem beschichteten Substrat 100 und dem Deckglassubstrat bzw. dem Deckglas 20 realisiert.

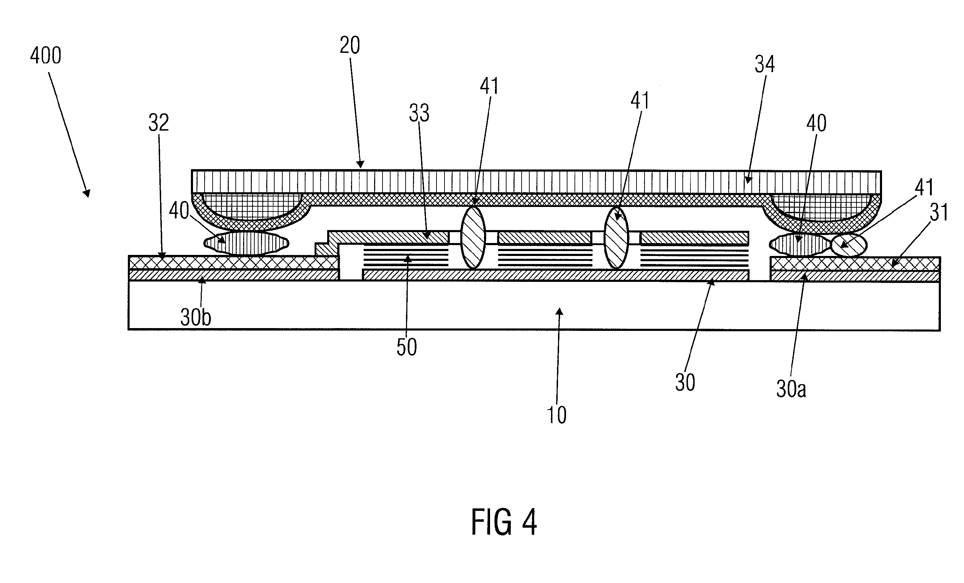

Fig. 4 zeigt eine Schnittansicht durch ein photoelektrisches Bauelement 400 gemäß einem vierten Ausführungsbeispiel der vorliegenden Erfindung. Das in Fig. 4 gezeigte organische photoelektrische Bauelement 400 unterscheidet sich zudem in Fig. 2 gezeigten organischen photoelektrischen Bauelement 200, analog zu den organischen photoelektrischen Bauelementen 300 und 100, durch die Nutzung eines additiven Verfahrens auf Basis strukturiert aufgeschmolzener Glasfrittenpaste zur Erzeugung von Kavitäten. Der Verkapselungsrand des Deckglases 20, also der von den Kavitäten ausgesparte Bereich wird auch hier beispielsweise in Form einer Paste aus Glasfritten aufgedruckt und anschließend bei geeigneten Temperaturen in das klare Deckglas eingebrannt.

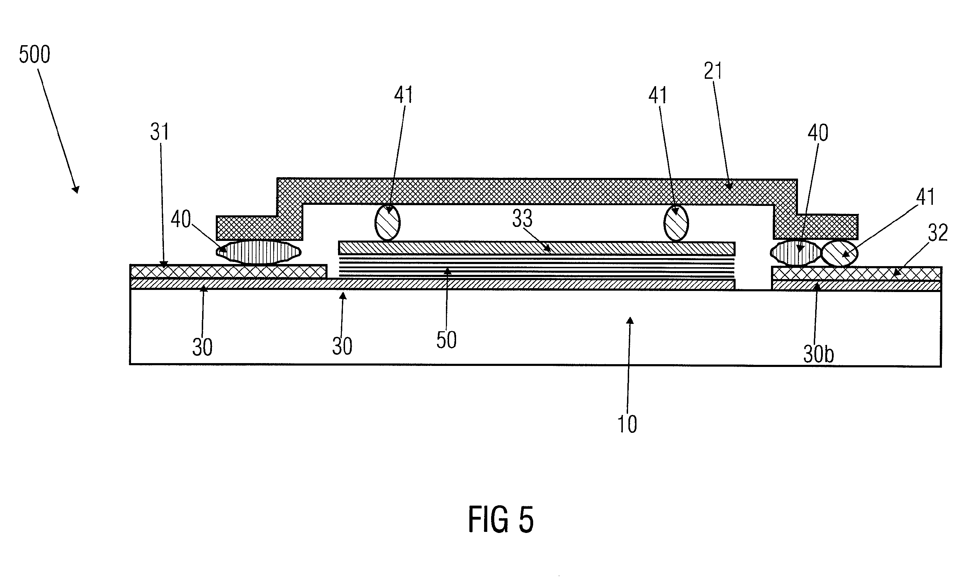

Fig. 5 zeigt eine Schnittansicht durch ein organischen photoelektrischen Bauelements 500 gemäß einem fünften Ausführungsbeispiel der vorliegenden Erfindung. Das in Fig. 5 gezeigte organische photoelektrische Bauelement 500 unterscheidet sich durch das in Fig. 1 gezeigte organische photoelektrische Bauelement 100 durch die Nutzung einer Deckplatte 21 aus Metallblech, anstatt eines Deckglases als selbsttragendes Deckbauglied. Durch Nutzung einer elektrisch leitfähigen Deckplatte 21, anstatt eines elektrisch nicht leitfähigen Deckglases ist eine elektrisch leitfähige Beschichtung des Deckbauglieds unnötig. Die elektrisch leitfähige Deckplatte 21 aus Metallblech ist neben dem Verkapselungsklebstoff 40 mit einem elektrisch leitfähigen Klebstoff 41 mit dem Kathodenanschluss der Substartmetallisierung 32 verbunden. Damit wird erreicht, dass die inaktiven Randbereiche minimiert werden, indem die Substratmetallisierung 32 nur noch die zur Verkapselung nötige Breite aufweist, und der Stromtransport bzw. die Stromverteilung hingegen durch die Deckplatte 21 erfolgt. Für den elektrisch leitfähigen Klebstoff 41 ist es ausreichend, wenn dieser nur an den Ecken, ggf. nur an einer Ecke ausgebracht wird, falls sich dort die Kathodenanschlussfläche der Substratmetallisierung 32 befindet. Der Strom wird mit Hilfe des elektrisch leitfähigen Klebstoffs 41 bzw. dem Leitklebstoff von der Substratmetallisierung 32 auf die Deckplatte 21 und von der Deckplatte 21 auf die Deckelelektrode 33 geführt. Durch diese Lösung ist es möglich, den Strom lediglich an einer Seite bzw. Ecke des organischen photoelektrischen Bauelements 500 einzuleiten, natürlich kann der Strom auch an mehreren Ecken, bzw. allen Ecken des organischen photoelektrischen Bauelements 500 eingeleitet werden. Die elektrisch leitende Deckplatte 21 sorgt für eine effiziente Verteilung des Stromes auf der Fläche bzw. ermöglicht eine elektrische Verschaltung verschiedener aktiver Module auf der Substratoberfläche.

Die Nutzung einer metallischen Deckplatte 21 eignet sich besonders für die Massenfertigung großflächiger OLEDs bzw. OPVZs, da sich die Deckplatten 21, beispielsweise durch Tiefziehen in großen Stückzahlen groß und preiswert fertigen lassen. Zudem fällt hierbei das aufwändige und umweltbelastende Ätzen der Deckglaskavitäten 22 für die Deckgläser weg. Weiterhin bietet die Verwendung einer Metalldeckplatte 21 eine bessere mechanische Stabilität, da das bruchempfindliche Glassubstrat von dem Metalldeckel 21 eingefasst wird.

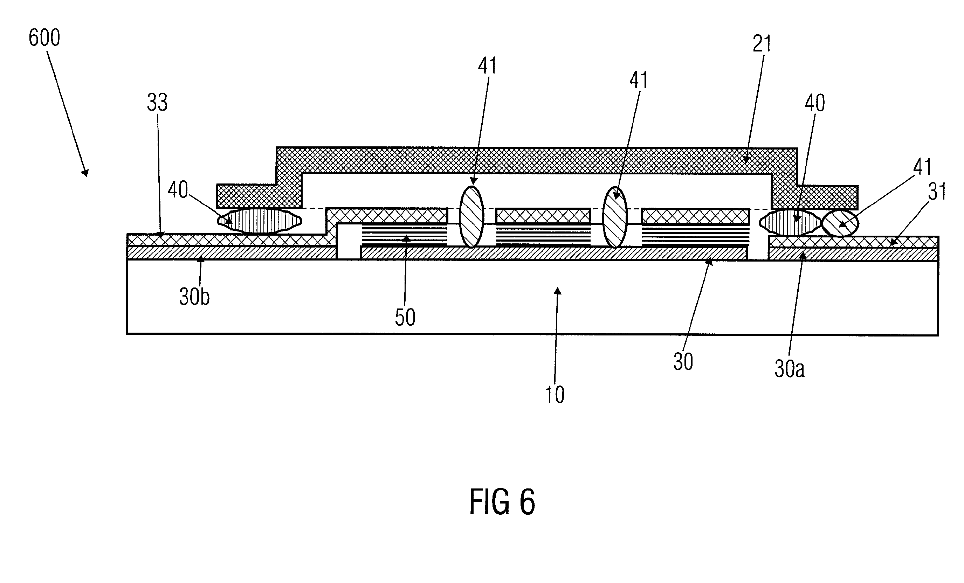

Fig. 6 zeigt eine Schnittansicht durch ein organischen photoelektrischen Bauelements 600 gemäß einem sechsten Ausführungsbeispiel der vorliegenden Erfindung. Das in Fig. 6 gezeigte organische photoelektrische Bauelement 600 unterscheidet sich durch das in Fig. 2 gezeigte organische photoelektrische Bauelement 200 durch die Nutzung einer Deckplatte 21 aus Metallblech, anstatt eines Deckglases als selbsttragendes Deckbauglied. Durch die Nutzung einer elektrisch leitfähigen Deckplatte 21 ist eine elektrisch leitfähige Beschichtung 34 des selbsttragenden Deckbauglieds unnötig. Die Deckplatte 21 aus Metallblech ist auch hier neben dem Verkapselungsklebstoff 40 mit einem elektrisch leitfähigen Klebstoff 41 mit dem Anodenanschluss der Substratmetallisierung 31 verbunden. Der Strom wird mit Leitklebstoff 41 von der Deckplatte 21 auf die transparente Grundelektrode 30 geführt. Hierfür sind in der Deckelelektrode 33 und in der organischen Funktionsschicht 50, also im Funktionsschichtstapel des organischen photoelektrischen Bauelements 600 elektrisch isolierte Durchkontaktierungsstellen vorgesehen. Die Nutzung einer elektrisch leitenden Deckplatte 21 ermöglicht es, den Strom lediglich an einer Seite bzw. Ecke des organischen photoelektrischen Bauelements 600 einzuleiten. Die elektrisch leitende Deckplatte 21 sorgt dabei für eine effiziente Verteilung des Stroms auf der gesamten Fläche. Weiterhin ist die Deckelelektrode 33 elektrisch leitfähig direkt mit der zweiten Grundteilelektrode 30b verbunden, das heißt ohne eine zusätzliche Substratmetallisierung 32 und bildet damit den Anodenanschluss.

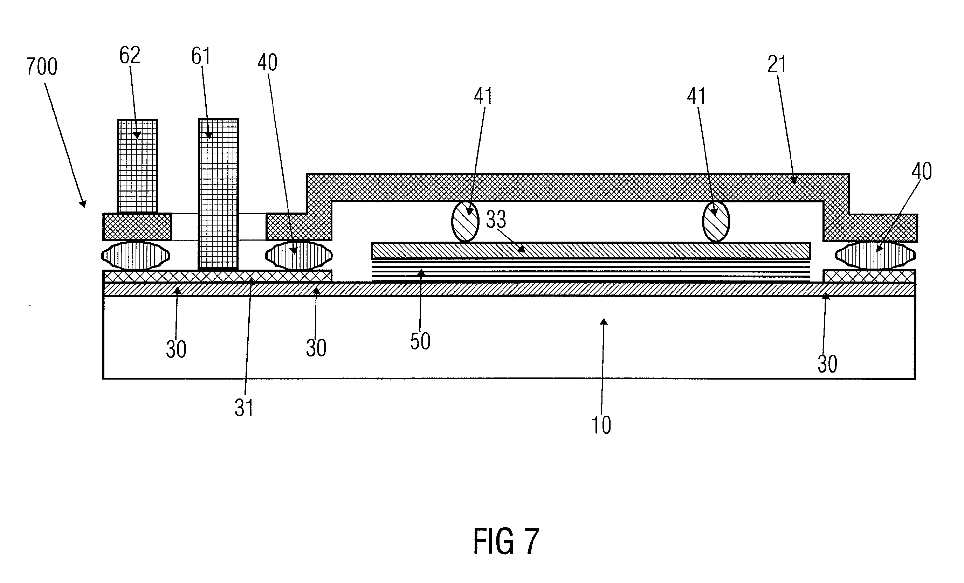

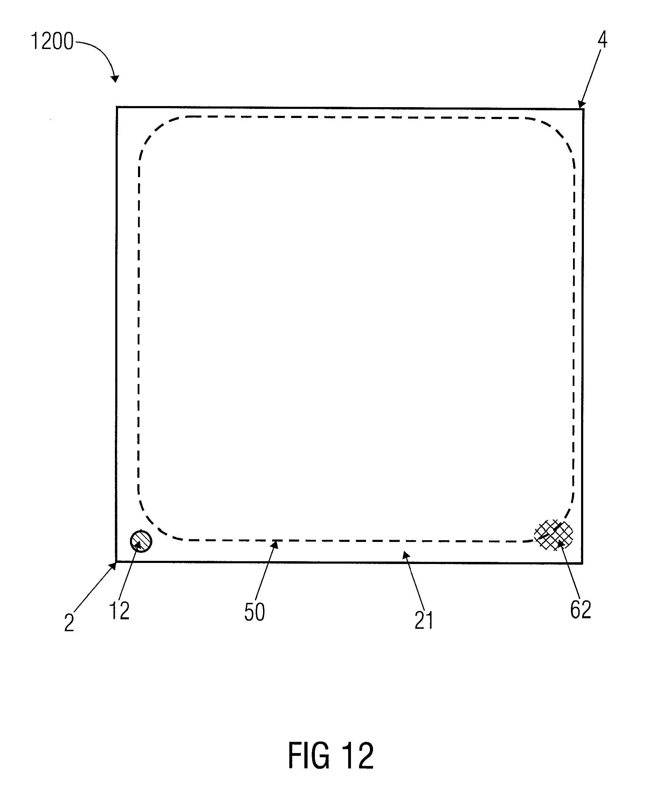

Fig. 7 zeigt eine Schnittansicht durch ein organisches photoelektrisches Bauelement 700 gemäß einem siebten Ausführungsbeispiel der vorliegenden Erfindung. Wie auch schon bei dem in Fig. 5 gezeigten organischen photoelektrischen Bauelement 500 wird bei dem in Fig. 7 gezeigten organischen photoelektrischen Bauelement 700 eine Deckplatte 21 aus Metallblech als selbsttragendes Deckbauglied genutzt. Die Deckplatte 21 ist elektrisch leitfähig mit einem Kathodenanschluss verbunden. Im Gegensatz zu den bisher gezeigten Aktionsbeispielen erfolgt der Anschluss der Kathode direkt auf die Deckplatte 21 beispielsweise mit Hilfe eines elektrisch leitfähigen Kontaktstifts 62, welcher auf einer dem Substrat 10 abgewandten Oberfläche der Deckplatte 21 ausgebildet ist. Natürlich kann der Anschluss der Kathode auch direkt auf die elektrisch leitfähige Deckplatte 21, beispielsweise durch Löten an einer beliebigen Stelle der Deckplatte 21 erfolgen. Das heißt, der Anschluss der Kathode erfolgt, entgegen den bisher gezeigten Ausführungsbeispielen nicht über eine Substratmetallisierung. Die Deckplatte 21 führt, wie auch schon bei dem ersten, dritten und fünften Ausführungsbeispiel den Strom über leitfähigen Klebstoff 41 auf die Deckelelektrode 33 ab. Die Anode hingegen wird über einen Kontaktstift 61 durch eine Aussparung bzw. Bohrung in der Deckplatte 21 auf die Substratmetallisierung 31 kontaktiert, welche auf der Grundelektrode 30 ausgebildet ist. Diese Aussparung/Bohrung ist sinnvoller Weise mit einem Ring aus Verkapselungsklebstoff 40 umgeben, um die organische Funktionsschicht 50 vor Umwelteinwirkungen zu schützen. Eine beispielhafte Anwendung hierfür zeigt Abbildung 12. Hier ist die nicht-emittierende bzw. nichtabsorbierende Rückseite eines organischen photoelektrischen Bauelements gemäß einem Ausführungsbeispiel der vorliegenden Erfindung dargestellt. Die Aussparung 12 in Form einer Bohrung, die die Kontaktierungsstelle der Anodenmetallisierung 31 darstellt, ist hierin nur an einer Ecke 2 des Elements verwirklicht. Die Kontaktierung der Kathode 62 kann hingegen an jeder anderen Stelle der Deckplatte 21 erfolgen. Sinnvoller Weise kann eine Anodenkontaktierung an zwei gegenüberliegenden Ecken 2 und 4 realisiert werden, da der Kontaktstift 61 gleichzeitig als Justierelement verwendet werden kann, insbesondere, wenn mehrere OLED/OPVZ-Elemente bzw. organische photoelektrische Bauelemente aneinandergereiht werden sollen. Ebenfalls ist denkbar, die Aussparungen 12 zur Kontaktierung der Anodenmetallisierung 31 an allen Ecken vorzusehen. Bei weiteren Ausführungsbeispielen können an allen Ecken Aussparungen 12 vorhanden sein, wobei aber nur ein Teil der Aussparungen 12 eine Kontaktierung der Anodenmetallisierung 31 ermöglichen, während der andere Teil nur zur Justierung der organischen photoelektrischen Bauelemente dient.

Da der Kontaktstift 61 für die Justierung der Vorrichtung auf dem Untergrund dient, berührt der Kontaktstift 61 zwangsläufig das Verkapselungsblech bzw. die Deckplatte 21. Aus diesem Grunde ist zwischen dem Kontaktstift 61 und der Deckplatte 21 bzw. dem Blech eine elektrische Isolation vorzusehen. Dies kann beispielsweise über einen nichtleitenden Ring geschehen, der in die Aussparung 12 bzw. um den Kontaktstift 61 herum angebracht wird und genau in die Aussparung 12 des Verkapselungsbleches bzw. der Deckplatte 21 passt. Der Ring kann dabei beispielsweise aus Verkapselungsklebstoff 40 bestehen.

Ebenso ist es möglich, dass der Kontaktstift 61 aus einem elektrisch leitenden Kern, der die Kontaktfläche der Substratmetallisierung 31 berührt und aus einer isolierenden Ummantelung, die den Rand der Aussparung 12 im Verkapselungsblech bzw. der Deckplatte 21 berührt, besteht.

Die verbesserte mechanische Stabilität, welche die Metalldeckplatte bietet, wird durch die Verwendung dieser Kontaktstifte 61 weiter verbessert, da hiermit zusätzlich eine einfache elektrische Kontaktierung sowie mechanische Befestigung ermöglicht wird.

Obwohl bei dem in Fig. 12 gezeigten organischen photoelektrischen Bauelement der Kontaktstift 61 als Anodenkontaktierung ausgebildet ist, um die Grundelektrode 30 zu kontaktieren und die Deckplatte 21 mit einer Kathode verbunden wird, um die Deckelelektrode 33 zu kontaktieren, so ist es auch möglich dass in einem weiteren Ausführungsbeispiel ein Kontaktstift 62 als Kathodenkontaktierungen ausgebildet ist, um die Deckelelektrode 33 zu kontaktieren und die Deckplatte 21 mit einer Anode verbunden wird, um die Grundelektrode 30 zu kontaktieren.

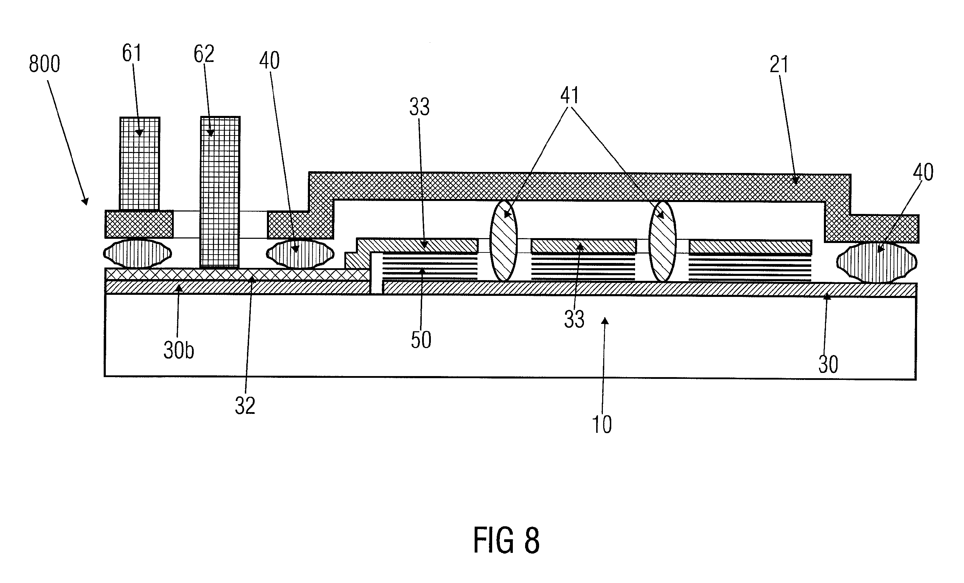

Fig. 8 zeigt eine Schnittansicht durch ein organisches photoelektrisches Bauelement 800 gemäß einem achten Ausführungsbeispiel der vorliegenden Erfindung. Wie auch schon in dem in Fig. 6 gezeigten organischen photoelektrischen Bauelement 600 ist das selbsttragende Deckbauglied, in dem in Fig. 8 gezeigten organischen photoelektrischen Bauelement 800 als eine Deckplatte 21 aus Metallblech ausgeführt. Das in Fig. 8 gezeigte organische photoelektrische Bauelement 800 unterscheidet sich durch das in Fig. 6 gezeigte photoelektrische Bauelement 600 dadurch, dass der Anschluss der Anode direkt auf die Deckplatte 21, beispielsweise mittels eines Kontaktstiftes 61 erfolgt und nicht über eine Substratmetallisierung. Die Deckplatte 21 führt, wie auch schon bei dem in Fig. 6 gezeigten organischen photoelektrischen Bauelement 600 den Strom über elektrisch leitfähigen Klebstoff 41 direkt auf die transparente Grundelektrode 30, wofür im Funktionsschichtstapel bzw. in der Deckelelektrode 33 und der organischen Funktionsschicht 50 der OLED/OPVZ bzw. dem organischen photoelektrischen Bauelement 800 elektrisch isolierte Durchkontaktierungsstellen vorgesehen sind. Weiterhin wird im Gegensatz zudem in Fig. 6 gezeigten organischen photoelektrischen Bauelement 600 die Kathode über einen Kontaktstift 62, vergleichbar dem Kontaktstift 61, gemäß Fig. 7, durch eine Aussparung bzw. Bohrung in der Deckplatte 21 auf der Substratmetallisierung 32 kontaktiert. Die Substratmetallisierung 32 ist weiterhin, wie auch schon im zweiten, vierten Ausführungsbeispiel gezeigt, direkt mit der Deckelelektrode 33 verbunden und auf einer dem Substrat 10 abgewandten Oberfläche eine Teilgrundelektrode 30b ausgebildet. Die Aussparung bzw. Bohrung zur Durchführung des Kontaktstiftes 62 in der Deckelelektrode 21 kann in einer oder mehreren Ecken der Deckplatte 21 realisiert sein und ist bevorzugt zwischen dem Substrat 10 und der Deckplatte 21 mit einem Ring aus Verkapselungsklebstoff 40 umgeben.

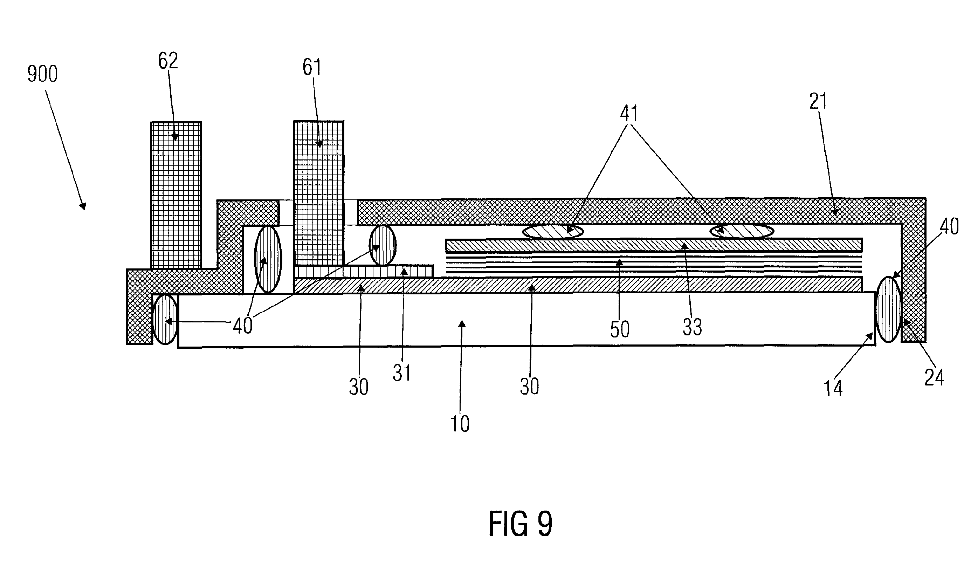

Fig. 9 zeigt eine Schnittansicht durch ein organisches photoelektrisches Bauelement 900 gemäß einem neunten Ausführungsbeispiel der vorliegenden Erfindung. Das in Fig. 9 gezeigte organische photoelektrische Bauelement 900 unterscheidet sich durch das in Fig. 7 gezeigte organische photoelektrische Bauelement 700 dadurch, dass die Deckplatte 21 aus Metallblech an ihren Rändern einen Kragen 24 aufweist, der beispielsweise durch Tiefziehen erzeugt wurde. Dadurch bildet die Deckplatte 21 eine Wanne aus, in die das beschichtete OLED/OPVZ-Substrat 10 eingelegt und verklebt wird. Der Kragen 24 der Deckplatte 21 dient als Verkapselungsfläche, auf die der Verkapselungsklebstoff 40 aufgetragen wird, um die organische Funktionsschicht vor Umwelteinflüssen zu schützen. Mit anderen Worten gesagt wird der Verkapselungsklebstoff zwischen dem Kragen 24 der Deckplatte 21 und Stirnseiten 14 des Substrates 10 aufgetragen und dichtet so den von der Deckplatte 21 umschlossenen Raum vor Umwelteinflüssen ab. Dadurch entfällt weitgehend die für die Verkapselung erforderliche Fläche auf der Substratoberfläche 11, womit der inaktive Randbereich des organischen photoelektrischen Bauelements 900 weiter minimiert wird. Die Kontaktierung der Kathode, beispielsweise mittels eines Kontaktstiftes 62 erfolgt analog zu dem siebten Ausführungsbeispiel direkt über die Deckplatte 21, wobei der Strom über leitfähigen Klebstoff 41 auf die Deckelelektrode 33 geleitet wird. Die Anode hingegen wird analog zu dem siebten Ausführungsbeispiel über einen Kontaktstift 61 durch eine Aussparung bzw. Bohrung in der Deckplatte 21 auf die Substratmetallisierung 31 kontaktiert. Die Aussparung bzw. Bohrung zur Durchführung des Kontaktstiftes 61 kann in einer oder mehreren Ecken der Deckplatte 21 realisiert sein und kann bevorzugt zwischen Substrat 10 und Deckplatte 21 mit einem Ring aus Verkapselungsklebstoff 40 umgeben sein.

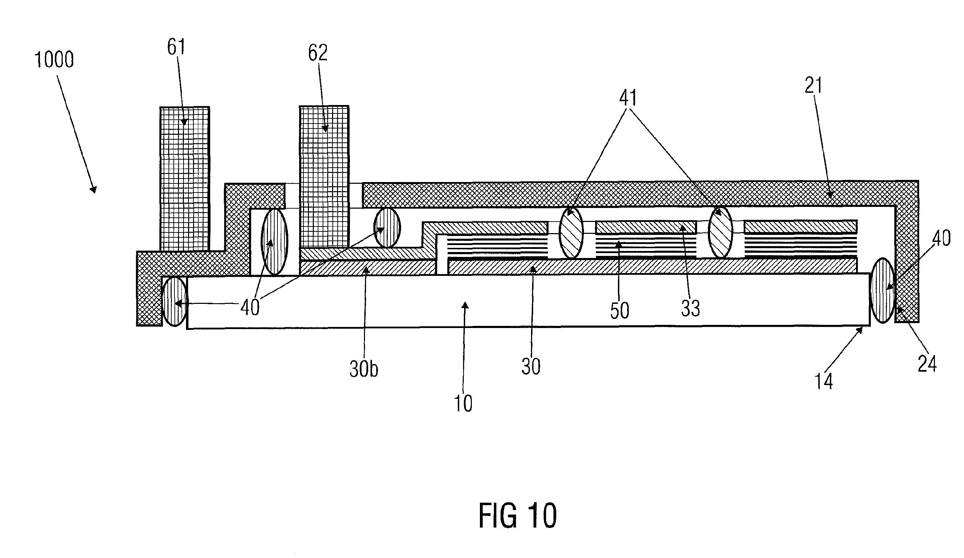

Fig. 10 zeigt eine Schnittansicht durch ein organisches photoelektrisches Bauelement 1000 gemäß einem zehnten Ausführungsbeispiel der vorliegenden Erfindung. Das in Fig. 10 gezeigte organische photoelektrische Bauelement 1000 unterscheidet sich durch das in Fig. 8 gezeigte organische photoelektrische Bauelement 800 dadurch, dass die Deckelelektrode 33, wie in dem in Fig.6 gezeigten organischen photoelektrische Bauelement 600 direkt mit der zweiten Teilgrundelektrode 30b, das heißt ohne eine zusätzliche Substratmetallisierung 32 elektrisch leitfähig verbunden ist und vor allem weiterhin dadurch, dass die Deckplatte 21 aus Metallblech an ihren Rändern einen Kragen 24 aufweist, der beispielsweise durch Tiefziehen erzeugt wurde. Dadurch bildet die Deckplatte 21 eine Wanne aus, in die das beschichtete OLED/OPVZ-Substrat 10 eingelegt und verklebt wird. Der Kragen 24 der Deckplatte 21 dient als Verkapselungsfläche, auf die der Verkapselungsklebstoff 40 aufgetragen wird. Mit anderen Worten gesagt wird der Verkapselungsklebstoff zwischen dem Kragen 24 der Deckplatte 21 und Stirnseiten 14 des Substrates 10 aufgetragen und dichtet so den von der Deckplatte 21 umschlossenen Raum vor Umwelteinflüssen ab. Dadurch entfällt weitgehend die für die Verkapselung erforderliche Fläche auf der Substratoberfläche 11, womit der inaktive Randbereich des organischen photoelektrischen Bauelements 1000 minimiert wird. Die Kontaktierung der Anode, beispielsweise mittels eines Kontaktstiftes 61 erfolgt, analog zu dem achten Ausführungsbeispiel direkt über die Deckplatte 21, wobei der Strom über leitfähigen Klebstoff 41 direkt auf die transparente Grundelektrode 30 geführt wird, wofür im Funktionsschichtstapel bzw. in der Deckelelektrode 33 und der organischen Funktionsschicht 50 der OLED/OPVZ bzw. dem organischen photoelektrischen Bauelement 1000 elektrisch isolierte Durchkontaktierungsstellen vorgesehen sind. Die Kathode wird analog zu dem achten Ausführungsbeispiel über einen Kontaktstift 62 durch eine Aussparung bzw. Bohrung in der Deckplatte auf der Substratmetallisierung 32 kontaktiert. Die Aussparung bzw. Bohrung zur Durchführung des Kontaktstiftes 61 kann in einer oder mehreren Ecken der Deckplatte 21 realisiert und bevorzugt zwischen Substrat 10 und der Deckplatte 21 mit einem Ring aus Verkapselungsklebstoff 40 umgeben sein.

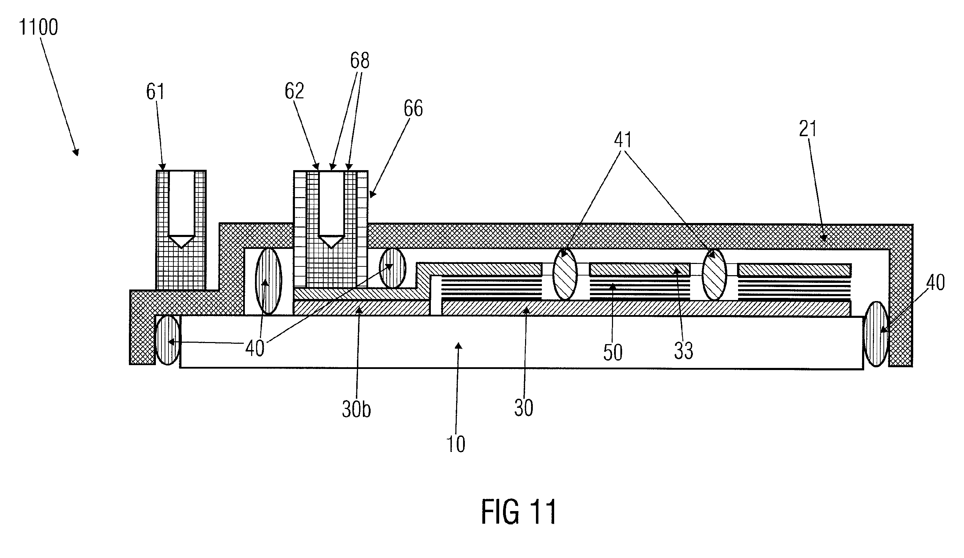

Fig. 11 zeigt eine Schnittansicht durch ein organisches photoelektrisches Bauelement 1100 gemäß einem elften Ausführungsbeispiel der vorliegenden Erfindung. Basierend auf dem in Fig. 10 gezeigten organischen photoelektrischen Bauelement 1000 weist das in Fig. 11 gezeigte organische photoelektrische Bauelement 1100 Kontaktstifte 61, 62 auf, die fest mit der Deckplatte 21 verbunden sind. Dies kann realisiert werden, indem die Kontaktstifte 61, 62 beispielsweise eingepresst oder eingeklebt werden. Die Kontaktstifte 61, 62 bzw. die Stifte weisen beispielsweise einen elektrisch leitfähigen Kern 64, beispielsweise aus Metall und eine elektrisch isolierende Ummantelung 66 auf. Der leitfähige Kern 64 ist beispielsweise mit einem leitfähigen Klebstoff mit den Kontaktflächen (sog. "Kontaktpads") auf dem OLED/OPVZ-Substrat 10 verbunden, das heißt, der leitfähige Kern 64 mindestens eines ersten Kontaktstiftes 61,62 ist mit der Deckplatte 21, welche elektrisch leitfähig mit der Grundelektrode 30 oder die Deckelelektrode 33 gekoppelt ist, verbunden und ein leitfähiger Kern 64 mindestens eines zweiten Kontaktstiftes 61, 62 ist mit einer Substratmetallisierung 31, 32 verbunden, welche elektrisch leitfähig mit der Deckelelektrode 33 oder der Grundelektrode 30 gekoppelt ist, wobei die elektrisch isolierende Ummantelung 66 des zweiten Kontaktstiftes 61, 62 mit der Deckplatte in Berührung kommt. Weiterhin kann beispielsweise im elektrisch leitfähigen Kern 64 auf der Außenseite, d. h. der dem Substrat 10 abgewandten Seite ein Innengewinde 68 ausgeführt sein, womit eine einfache Montage der Vorrichtung bzw. dem organischen photoelektrischen Bauelement 1100 ermöglicht wird. Weiterhin kann der elektrisch leitfähige Kern 64 ebenso als Dauermagnet ausgeführt sein, in dem dieser aus einem magnetisierten Material besteht.

Obwohl in den gezeigten Ausführungsbeispielen die organischen photoelektrischen Bauelemente als Substratemitter ausgebildet sind, so ist es auch denkbar dass die leitfähige Beschichtung des selbstragenden Deckbauglieds und das selbsttragende Deckbauglied für die Nutzwellenlänge organischer photoelektrischer Bauelemente transparent sind und Ausführungsbeispiele als Substratabsorber ausgebildet sind.

Weiterhin kann bei einem weiteren Ausführungsbeispiel der vorliegenden Erfindung das elektrisch leitfähige Material mit der Deckelelektrode elektrisch leitfähig gekoppelt sein und das selbstragende Deckbauglied, ein weiteres von der Deckelektrode und dem mit der Deckelelektrode elektrisch leitfähig gekoppelten Material, elektrisch isoliertes elektrisch leitfähiges Material aufweisen. Das weitere elektrisch leitfähige Material kann beispielsweise über von der Deckelelektrode und der organischen Funktionsschicht isolierte Durchkontaktierungen mit der Grundelektrode elektrisch leitfähig gekoppelt sein. Im Falle des leitfähigen selbstragenden Deckbauglieds, kann das leitfähige selbstragende Deckbauglied beispielsweise zwei durch elektrische Isolationsschichten getrennte elektrisch leitfähig Materialien aufweisen. Im Falle der Beschichtung des selbstragenden Deckbauglieds, kann das selbstragende Deckbauglied lokal an lateral verteilten Orten elektrisch voneinander isolierte leitfähige Materialien aufweisen, wobei bevorzugt die Orte miteinander elektrisch gekoppelt sind welche die selbe Elektrode elektrisch leitfähig koppeln. So ist beispielsweise eine Streifenanordnung der beiden elektrisch leitfähigen Materialien denkbar. Durch eine elektrisch leitfähige Kopplung der Deckelelektrode sowie der Grundelektrode mit leitfähigen Material des selbstragenden Deckbauglieds wird ein vollständiger Verzicht auf Metallnetze zur Senkung des Schichtwiderstand von Grundelektrode und/oder Deckelektrode ermöglicht, was zu einer einfacheren Herstellung und einer besseren Ausnutzung der optisch aktiven Fläche führt.

Ein weiteres Ausführungsbeispiel der vorliegenden Erfindung kann als eine organische Leuchtdiode oder eine organische Solarzelle, bestehend aus Substraten, Grundelektrode, organische Schichten, Deckelelektrode und Verkapselung, der im Verkapselungsglas mit metallischen Leiterbahnen versehen ist und auf dem OLED/OPVZ-Substrat aufgeklebt wird, ausgebildet sein. Die Metallleitbahnen auf diesem Verkapselungsglas sind beispielsweise mittels eines elektrisch leitfähigen Klebstoffs, sowohl mit Deckelelektrode der OLED/OPVZ, als mit den Randkontaktflächen auf dem Substrat verbunden und das Kapselungsglas mit einer gehetzten oder gefrästen Kavität versehen.

Ein weiteres Ausführungsbeispiel der vorliegenden Erfindung kann als eine organische Leuchtdiode oder eine organische Solarzelle, bestehend aus Substraten, Grundelektrode, organische Schichten, Deckelelektrode und Verkapselung, der im Verkapselungsglas mit metallischen Leiterbahnen versehen ist und auf dem OLED/OPVZ-Substrat aufgeklebt wird, ausgebildet sein. Die Metallleitbahnen auf diesem Verkapselungsglas sind beispielsweise mittels eines elektrisch leitfähigen Klebstoffs, sowohl mit der Grundelektrode der OLED/OPVZ über eine von der Deckelelektrode elektrisch isolierte Durchkontaktierung als auch mit den Randkontaktflächen auf dem Substrat verbunden. Das Kapselungsglas ist hierbei mit einer geätzten oder gefrästen Kavität versehen.

Ein weiteres Ausführungsbeispiel der vorliegenden Erfindung kann als eine organische Leuchtdiode oder organische Solarzelle, bestehend aus einem Substrat, Grundelektrode, organische Schichten, Deckelelektrode und Verkapselung, der im Verkapselungsglas mit metallischen Leiterbahnen versehen ist und auf dem OLED/OPVZ-Substrat aufgeklebt wird, ausgebildet sein. Die Metallleitbahnen auf diesem Verkapselungsglas sind beispielsweise mittels eines elektrisch leitfähigen Klebstoffes, sowohl mit der Deckelelektrode der OLED/OPVZ, als auch mit den Randkontaktflächen auf dem Substrat verbunden. Das Kapselungsglas besteht aus einem planen Substrat. Die Kavität, eine flächige Vertiefung des Verkapselungsglases, wird durch einen Glasfrittenrahmen erzeugt, der vor der Verkapselung mittels eines geeigneten Druckprozesses an den mit Verkapselungsklebstoff zu versehenden Kontaktstellen mit dem Substrat aufgebracht und eingebrannt wird.

Ein weiteres Ausführungsbeispiel der vorliegenden Erfindung kann als eine organische Leuchtdiode oder organische Solarzelle, bestehend aus Substrat, Grundelektrode, organischen Schichten, Deckelelektrode und Verkapselungsglas, der ein Verkapselungsglas mit metallischen Leiterbahnen versehen ist und auf dem OLED/OPVZ-Substrat aufgeklebt wird, ausgeführt sein. Die Metallleitbahnen auf diesem Verkapselungsglas sind beispielsweise mittels eines elektrisch-leitfähigen Klebstoffes, sowohl mit der Grundelektrode der OLED/OPVZ über eine von der Deckelelektrode elektrisch isolierten Durchkontaktierung, also auch mit den Randkontaktflächen auf dem Substrat verbunden. Das Kapselungsglas besteht aus einem planen Substrat. Die Kavität, eine flächige Vertiefung des Verkapselungsglases wird durch einen Glasfrittenrahmen erzeugt, der vor der Verkapselung mittels eines geeigneten Druckprozesses an den mit Verkapselungsklebstoff zu versehenden Kontaktstellen mittels Substrat aufgebracht und eingebrannt wird.

Ein weiteres Ausführungsbeispiel der vorliegenden Erfindung kann als eine durch das Substrat emittierende bzw. absorbierende OLED/OPVZ ausgebildet sein, bestehend aus Substraten, transparenter Grundelektrode, organischen Schichten, Deckelelektrode und Verkapselung, der ein Verkapselungselement aus Metall auf dem OLED/OPVZ-Substrat aufgeklebt wird und zur elektrischen Kontaktierung, sowohl mit der Deckelelektrode der OLED/OPVZ als auch mit einer externen Stromversorgung bzw. Ansteuerelektronik dient.

Ausführungsbeispiele der vorliegenden Erfindung in der ein Verkapselungselement aus Metall ist, können an den Ecken Aussparungen und Bohrungen aufweisen, die mit Verkapselungsklebstoff umschlossen sind, und eine von dem Verkapselungselement elektrisch isolierte Kontaktierung der Grundelektrode der OLED/OPVZ mit einer externen Stromversorgung bzw. Ansteuerelektronik ermöglichen.

Ein weiteres Ausführungsbeispiel der vorliegenden Erfindung kann als eine durch das Substrat emittierende/absorbierende OLED/OPVZ ausgebildet sein, bestehend aus Substrat, Grundelektrode, organische Schichten, Deckelelektrode und Verkapselung, der ein Verkapselungselement aus Metall auf dem OLED/OPVZ-Substrat aufgeklebt wird, und zur elektrischen Kontaktierung sowohl mit der Grundelektrode oder OLED/OPVZ über eine von der Deckelelektrode elektrisch isolierte Durchkontaktierung, als auch mit einer externen Stromversorgung bzw. Ansteuerelektronik dient.

Ausführungsbeispiele der vorliegenden Erfindung, der ein Verkapselungselement aus Metall ist, können an den Ecken Aussparungen bzw. Bohrungen aufweisen, die mit Verkapselungsklebstoff umschlossen sind und eine von dem Verkapselungselement elektrisch isolierte Kontaktierung mit der Deckelelektrode der OLED/OPVZ mit einer externen Stromversorgung bzw. Ansteuerelektronik ermöglichen.

Bei Ausführungsbeispielen der vorliegenden Erfindung, bei denen das Verkapselungselement aus Metall, größer als das OLED/OPVZ-Glassubstrat ist, kann das Verkapselungselement zur mechanischen Befestigung des OLED/OPVZ-Elementes dienen.

Bei weiteren Ausführungsbeispielen der vorliegenden Erfindung kann das Verkapselungselement in Form einer Wanne aus einer beispielsweise tiefgezogenen Metallblech ausgebildet sein, in der das Substrat liegt, und zumindest an den seitlichen Stirnflächen des Substrates mit dem Substrat verklebt sein.

Bei weiteren Ausführungsbeispielen der vorliegenden Erfindung kann das Verkapselungselement aus magnetischem Metallblech hergestellt sein, welches zur mechanischen Fixierung des OLED/OPVZ-Elementes genutzt werden kann.

Bei weiteren Ausführungsbeispielen der vorliegenden Erfindung kann das Verkapselungselement gebogen sein und aus magnetischem Metallblech bestehen, wodurch in Verbindung mit der Verwendung von flexiblen Substraten, wie beispielsweise transparenten Folien oder Dünnglas als OLED/OPVZ-Substrat ein gebogenes OLED/OPVZ-Element bzw. organisches photoelektrisches Bauelement erzeugt werden kann, so dass die OLED/OPVZ über das Verkapselungselement in eine Anwendungsvorrichtung montierbar ist.

Bei weiteren Ausführungsbeispielen der vorliegenden Erfindung kann das Verkapselungselement als ein Verkapselungsglas ausgeführt sein, wobei das Verkapselungsglas idealerweise eine mit dem Substrat identische Größe besitzt und an den Ecken Löcher aufweist, die eine Kontaktierung der Kontaktflächen auf dem Substrat ermöglichen.

Bei weiteren Ausführungsbeispielen der vorliegenden Erfindung kann in die Kontaktierungsbohrung bzw. Kontaktierungslöcher des Verkapselungselements ein Kontaktstift eingebracht werden, welcher eine einfache Kontaktierung der Vorrichtung bzw. der Elektrodenanschlüsse ermöglicht und aus einem elektrisch leitfähigen Material besteht. Der in die Kontaktierungsbohrung bzw. Kontaktierungslöcher des Verkapselungselements eingebrachte Kontaktstift kann beispielsweise einen elektrisch leitfähigen Kern und eine isolierende Ummantelung aufweisen, weiterhin kann der Kontaktstift als Dauermagnet ausgeführt sein und beispielsweise ein Innengewinde aufweisen.

Bei weiteren Ausführungsbeispielen der vorliegenden Erfindung ist der vollständige Verzicht auf Kavitäten möglich, wenn beispielsweise die Funktionsschichten der OLED/OPVZ bzw. die organische Funktionsschicht 50 vollflächig mit Verkapselungsklebstoff 40 versehen werden. Damit ist auch eine einfache Metallisierung des Deckglases 21 möglich.

Mit anderen Worten lässt sich sagen, dass bei weiteren Ausführungsbeispielen der vorliegenden Erfindung das Deckglas, ähnlich dem Substrat mit einer Metallisierung, der Deckglasmetallisierung versehen ist. Dies hat den Zweck, den auf die Metallisierung des Deckglases eingeleiteten Strom mittels eines elektrisch leitenden Klebstoffs auf das Deckglas zu führen. Die Deckglasmetallisierung leitet den Strom zu weiteren Kontaktpunkten, die sich an den anderen Stellen des Randbereiches oder verteilt auf der gesamten Fläche des Deckglases befinden können, die wiederum mittels elektrisch leitfähigen Klebstoff auf die Deckelektrode bzw. die Grundelektrode den Strom führen. Somit kann eine gleichmäßige Stromverteilung über die gesamte Fläche ermöglicht werden.

Bei weiteren Ausführungsbeispielen kann statt der Deckglasmetallisierung auch ein Deckelement beispielsweise ein Verkapselungsblech aus Metall, oder einem anderen leitenden Material zum Einsatz kommen.

Dies hat den Vorteil, dass der nichtleuchtende Randbereich weiter minimiert werden kann, indem dieses Verkapselungsblech am Rand einen Kragen aufweist, der die Substratstimseiten bzw. Stirnseiten des Substrates umschließt. Die Verkapselung erfolgt dann zusätzlich zum Randbereich der Beschichtungsseite des Substrates an den Substratstirnseiten. Dafür kann die Breite des Verklebebereichs auf der beschichteten Seite, also auf einer nicht Substratstirnseite reduziert werden unter Beibehaltung der Stabilität der "Klebenaht".

Bei einer solchen Vorrichtung dient das metallische Verkapselungselement als Kontaktelement für die Kathode oder die Anode, je nach Ausführung der Vorrichtung bzw. des organischen photoelektrischen Bauelements.

Für die Kontaktierung der jeweils anderen Elektrode weist das Verkapselungsblech vorzugsweise an den Ecken Bohrungen/Löcher auf. Über diese Löcher kann über einen Kontaktstift die Kontaktierung des Substrates realisiert werden. Der Kontaktstift kann entweder fest mit dem Substrat/Verkapselungselement verbunden sein oder von außen eingebracht werden.

Im Falle einer festen Integration des Kontaktstiftes in die OLED/OPVZ ist dieser Kontaktstift vorzugsweise magnetisch oder weist eine Bohrung mit Innengewinde auf. Damit kann gleichzeitig zur elektrischen Kontaktierung die mechanische Befestigung der Vorrichtung gewährleistet werden.

Im Falle der Verwendung eines magnetischen Kontaktstiftes ist dieser Vorzugsweise konisch ausgeführt sodass bei einer Platzierung einer OLED/OPVZ-Vorrichtung in einer Halterung, welche mit Bohrungen versehen ist, die dem konischen Stift entsprechend eine Fase aufweisen eine Selbstpositionierung der Vorrichtung ermöglichen.

Somit sorgt der Stift neben der elektrischen Kontaktierung, und der mechanischen Befestigung ebenfalls für eine exakte Positionierung in einer Halterung, was insbesondere beim Nebeneinanderreihen mehrerer OLED/OPVZ-Vorrichtungen von Bedeutung ist.

Bei Verwendung eines Kontaktstiftes mit einem metallischen Verkapselungselement muss eine elektrische Isolierung von Kontaktstift und Verkapselungselement gewährleistet sein, was beispielsweise über die Verklebung oder eine Kunststoffummantelung des Kontaktstiftes realisiert werden kann.

Ausführungsbeispiele der vorliegende Erfindung ermöglichen damit, nicht leuchtende bzw. optisch nicht aktive Bereiche eines organischen photoelektrischen Bauelementes bzw. einer OLED/OPVZ zu reduzieren, indem Randflächen der einzelnen OLED- bzw. OPVZ-Elemente durch eine Kombination von Kontakt- und Verkapselungsflächen minimiert werden, was damit die Herstellung großer Leuchtflächen bzw. optisch aktiver Flächen mit einem hohen Füllgrad ermöglicht. Durch die in den gezeigten Ausführungsbeispielen dargestellte Verkapselung mit Alternativen bzw. strukturierten Verkapselungssubstraten werden großflächige OLEDs/OPVZ-Elemente mit minimalen, für Verkapselung und Kontaktierung erforderlichen inaktiven Randbereichen ermöglicht.

Dies ermöglicht die Herstellung großformatiger OLED-Leuchtelemente und organischer Solarzellen (OPVZ) mit geringen inaktiven Randbereichen und damit einen besseren optischen Eindruck bei Aneinanderreihung mehrerer OLED-Elemente und eine bessere Flächenausnutzung bei Aneinanderreihung mehrerer OPVZ-Elemente durch geringe und damit weniger sichtbare inaktive Bereiche zwischen den einzelnen Elementen. Weiterhin ermöglichen Ausführungsbeispiele der Erfindung einen Verzicht auf aufwändig herzustellende Deckgläser mit Kavitäten, welche dadurch in größeren Mengen preiswerter und dadurch insgesamt umweltfreundlicher produzierbar sind. Weiterhin zeichnen sich Ausführungsbeispiele der vorliegenden Erfindung durch eine einfache Kontaktierung der OLED/OPVZ-Elemente und eine einfachere Befestigung/Montage und Handhabung der OLED/OPVZ-Elemente durch größere mechanische Stabilität der Vorrichtung aus. Dies führt im Allgemeinen zu einer größeren Robustheit der OLED/OPVZ-Elemente.

## Patentansprüche

1. Organisches photoelektrisches Bauelement mit:
einem Substrat (10):
einer Grundelektrode (30), die auf einer ersten Oberfläche (11) des Substrates (10) ausgebildet ist;
einem von oberhalb der ersten Oberfläche (11) des Substrates (10) zugänglichen ersten Elektrodenanschluss (31, 32, 61, 62);
einer Deckelelektrode (33);
einer organischen Funktionsschicht (50), die zwischen der Grundelektrode (30) und der Deckelelektrode (33) angeordnet ist;
einem selbsttragenden Deckbauglied (20, 21) zum Verkapseln der organischen Funktionsschicht (50) zwischen dem Substrat (10) und dem selbsttragenden Deckbauglied (20, 21), wobei das selbsttragende Deckbauglied (21, 21) aus leitfähigem Material gebildet ist oder mit einem leitfähigen Material an einer dem Substrat (10) zugewandten Seite beschichtet ist;
wobei das leitfähige Material lokal an lateral verteilten Orten mit der Grundelektrode (30) oder der Deckelelektrode (33) leitfähig gekoppelt ist; und
wobei das leitfähige Material mit dem ersten Elektrodenanschluss (31, 32, 61, 62) elektrisch leitfähig gekoppelt ist.

2. Organisches photoelektrisches Bauelement gemäß Anspruch 1,
ferner aufweisend einen zweiten Elektrodenanschluss (31, 32, 61, 62), wobei der zweite Elektrodenanschluss (31, 32, 61, 62) mit derjenigen der Grundelektrode (30) oder der Deckelelektrode (33) elektrisch leitfähig gekoppelt ist, die nicht mit dem leitfähigen Material elektrisch leitfähig gekoppelt ist; und
wobei der zweite Elektrodenanschluss (31, 32, 61, 62), auf der ersten Oberfläche (11) des Substrates (10) angeordnet ist und einen von dem Deckbauglied verkapselten Bereich lateral überragt.

3. Organisches photoelektrisches Bauelement gemäß einem der Ansprüche 1 oder 2,
das ausgebildet ist, um Licht durch das Substrat (10) hindurch zu emittierten oder zu absorbieren.

4. Organisches photoelektrisches Bauelement gemäß einem der Ansprüche 1 bis 3,
bei dem das leitfähige Material an den lateral verteilten Orten auf einer dem Substrat (10) abgewandten Oberfläche der Grundelektrode (30) oder der Deckelelektrode (33) angeordneten Portionen elektrisch leitfähigen Haftmittels (41) elektrisch leitfähig mit der Grundelektrode (30) oder der Deckelelektrode (33) gekoppelt ist.

5. Organisches photoelektrisches Bauelement gemäß einem der Ansprüche 1 bis 4,
bei dem das selbsttragende Deckbauglied (20,21) eine Glasplatte (20) mit einer Kavität (22), zur Aufnahme der organischen Funktionsschicht (50) aufweist.

6. Organisches photoelektrisches Bauelement gemäß einem der Ansprüche 1 bis 4,
bei dem das selbsttragende Deckbauglied (20,21) eine Glasplatte (20) aufweist, wobei auf einer dem Substrat (10) zugewandten Seite der Glasplatte (20) ein Rahmen zwischen der ersten Oberfläche (11) des Substrates (10) und der Glaspatte (20) angeordnet ist, so dass die organische Funktionsschicht (50) in einem Hohlraum angeordnet ist, der von dem Substrat (10), der Glasplatte (20) und dem Rahmen begrenzt wird.

7. Organisches photoelektrisches Bauelement gemäß einem der Ansprüche 1 bis 4,
bei dem das selbsttragende Deckbauglied (20,21) ein Metallverschlussdeckel (21) ist.

8. Organisches photoelektrisches Bauelement gemäß Anspruch 7,
bei dem der Metallverschlussdeckel (21) eine Umrandung (24) umfasst, die an Seitenoberflächen (14) des Substrates (10) befestigt ist.

9. Organisches photoelektrisches Bauelement gemäß einem der vorherigen Ansprüche, das ferner folgendes aufweist:
von der Deckelelektrode (33) und der organischen Funktionsschicht (50) elektrisch isolierte Durchkontaktierungen, die lokal an den lateral verteilten Orten angeordnet sind, über die das leitfähige Material elektrisch leitfähig mit der Grundelektrode (30) gekoppelt ist.

10. Organisches photoelektrisches Bauelement gemäß einer der vorherigen Ansprüche mit:
einem zweiten Elektrodenanschluss (31, 32, 61, 62), wobei der zweite Elektrodenanschluss (31, 32, 61, 62) mit derjenigen der Grundelektrode (30) oder der Deckelelektrode (33) elektrisch leitfähig gekoppelt ist, die nicht mit dem leitfähigen Material elektrisch leitfähig gekoppelt ist.

11. Organisches photoelektrisches Bauelement gemäß Anspruch 7 oder 8 mit:
einem zweiten Elektrodenanschluss (31, 32, 61, 62), wobei der zweite Elektrodenanschluss (30, 31, 61, 62) als ein von dem Metallverschlussdeckel (21) isolierter, elektrisch leitfähiger Kontaktstift (61,62) ausgebildet ist; und
wobei der Metallverschlussdeckel (21) eine Bohrung umfasst, durch die sich der elektrisch leitfähige Kontaktstift (61, 62) erstreckt, um den elektrisch leitfähigen Kontaktstift (61, 62) mit der derjenigen der Grundelektrode (30) oder der Deckelelektrode (33) elektrisch leitfähig zu koppeln, die nicht mit dem leitfähigen Material elektrisch leitfähig gekoppelt ist.

12. Organisches photoelektrisches Bauelement gemäß Anspruch 11,
bei dem der Kontaktstift (61, 62) als ein Dauermagnet ausgebildet ist.

13. Organisches photoelektrisches Bauelement gemäß einem der Ansprüche 10 oder 11,
bei dem der Kontaktstift (61, 62) ein Innengewinde (68) und/oder einen elektrisch leitfähigen Kern (64) und/oder eine elektrisch nicht leitfähige Ummantelung (66) umfasst.

14. Organisches photoelektrisches Bauelement gemäß einem der Ansprüche 1 bis 13,
wobei das organische photoelektrische Bauelement als eine durch das Substrat emittierende organische lichtemittierende Diode (OLED) oder als eine durch das Substrat absorbierende organische Photovoltaikzelle (OPVZ) ausgebildet ist.

15. Organisches photoelektrisches Bauelement gemäß einem der Ansprüche 1 bis 14,
bei dem das leitfähige Material mit der Deckelektrode (30) leitfähig gekoppelt ist, und das selbstragende Deckbauglied (21) ferner ein weiteres leitfähiges Material aufweist, dass von dem leitfähigen Material, das lokal an lateral verteilen Orten mit der Deckelelektrode (30) elektrisch leitfähig gekoppelt ist, elektrisch isoliert ist, lokal an weiteren lateral verteilten Orten über von der Deckelelektrode (30) und der organischen Funktionsschicht (50) elektrisch isolierten Durchkontaktierungen mit der Grundelektrode (30) elektrisch leitfähig gekoppelt ist und mit einem weiteren Elektrodenanschluss elektrisch leitfähig gekoppelt ist.
